# EUROPEAN PATENT APPLICATION

(11) **EP 4 485 540 A1**
(43) Date of publication of application: **01.01.2025**
(21) Application number: 23181483.1
(22) Date of filing: 26.06.2023
(51) Int. Cl.: H01L 29/06, H01L 29/423, H01L 29/66, H01L 29/775, B82Y 10/00

(54) **A FORKSHEET DEVICE WITH TWO NANOSHEET TRANSISTORS AND A DIELECTRIC WALL**

(71) Applicant: IMEC VZW, 3001 Leuven (BE)
(72) Inventor: HELLINGS, Geert, 1500 Halle (BE); SCHUDDINCK, Pieter, 9320 Nieuwerkerken (Aalst) (BE)
(74) Representative: AWA Sweden AB

(57) **Abstract**

Provided herein is a nanosheet / forksheet device (100) comprising a first (110) and a second (120) nanosheet transistor structure, each (110, 120) comprising a source region, a drain region, and a channel region (112, 122) extending between the source and the drain region, a dielectric wall (140), a gate structure (150), and a inner gate spacer between the nanosheets, the gate and the source and drain regions. The channel region of the first transistor structure comprises a first set (112) of vertically stacked nanosheet channel layers, wherein each channel layer of the first set (112) of vertically stacked channel layers has an inward facing surface (113) contacting a first side surface (142) of the dielectric wall (140), and wherein the channel region of the second transistor structure comprises a second set (122) of vertically stacked nanosheet channel layers, wherein each channel layer of the second set (122) of vertically stacked channel layers has an inward facing surface (123) contacting a second side surface (144), opposite to the first side surface (142), of the dielectric wall (140). A a top portion (152) of the gate structure (150) is arranged above a top surface (141) of the dielectric wall (140), and material of the gate spacer (160) is also arranged at the third (146) and fourth (148) side surfaces of the dielectric wall (140), adjacent the source and drain regions, the third (146) and the fourth (148) side surface being transverse to the first (142) and the second (144) side surface of the dielectric wall (140).

## Description

### TECHNICAL FIELD

The present disclosure relates to nanosheet devices.

### BACKGROUND

In the strive to provide even more area-efficient circuit designs, nonplanar transistor devices have been developed, such as the FinFET and the horizontal or lateral nanosheet FET (NSHFET). In a NSHFET a number of nanosheets may be stacked in the vertical dimension to provide an increased drive current with a reduced horizontal footprint. A more recent NSHFET design is the so-called forksheet device. The forksheet device comprises two transistors of complementary conductivity types comprising a respective set of vertically stacked channel nanosheets on opposite sides of a vertically oriented dielectric wall. The transistors are controlled by a respective gate stack separated by the dielectric wall. The dielectric wall may be formed before gate patterning and source/drain epitaxy, S/D epi, and may hence facilitate individual processing of N- and P-type source/drain regions and gate stacks for the two transistors. The forksheet device hence enables aggressive scaling of the N-to-P spacing.

However, nanosheet devices in general, and forksheet devices in particular, still face challenges due to its ongoing downsizing, and thus call for improvements to overcome difficulties associated therewith, e.g., avoiding N/P merging over the dielectric wall, and/or reducing the relatively large number of etchback steps during replacement metal gate, RMG, formation. Further, the relatively narrow wall normally present in forksheet devices complicates (fin) formation upon nanosheet stack etching.

### SUMMARY

It is an objective to provide an overall improved nanosheet device.

It is another objective to provide a nanosheet device associated with a reduced epi source/drain and gate metal shorting.

It is another objective to provide a nanosheet device having a smaller footprint area.

It is another objective to provide a nanosheet device having a smaller capacitance at cell level.

It is another objective to provide a nanosheet device having a reduced parasitic series resistance.

It is another objective to provide a nanosheet device being easier to manufacture.

Further and alternative objectives may be understood from the following.

According to a first aspect of the inventive concept there is provided a nanosheet device comprising a first and a second transistor structure, each comprising a source region, a drain region, and a channel region extending between the source and the drain region, a dielectric wall, a gate structure, and a gate spacer, wherein the channel region of the first transistor structure comprises a first set of vertically stacked channel layers, wherein each channel layer of the first set of vertically stacked channel layers has an inward facing surface contacting a first side surface of the dielectric wall, and wherein the channel region of the second transistor comprises a second set of vertically stacked channel layers, wherein each channel layer of the second set of vertically stacked channel layers has an inward facing surface contacting a second side surface, opposite to the first side surface, of the dielectric wall, wherein a top portion of the gate structure is arranged above a top surface of the dielectric wall, and wherein the gate spacer is arranged at a third and a fourth side surface of the dielectric wall, the third and the fourth side surface being transverse to the first and the second side surface of the dielectric wall.

Hence, it is to be understood that the dielectric wall is enclosed by the first and second set of vertically stacked channel layers, the gate structure, and the gate spacer. This in contrast to conventional forksheet devices, where the dielectric wall is present also in the S/D region.

This geometrical configuration of layers/components facilitates easier manufacturing since the dielectric wall may be made relatively wide without compromising with the footprint area of the nanosheet device. That is, the distance between the two vertically stacked channel layers may be relatively large. The "width" of the dielectric wall is thus understood as being (the closest) distance between the first and the second set of vertically stacked channel layers, i.e., along a horizontal extension being transverse to the direction in which electron/hole transport takes place in one of the nanosheets.

The present nanosheet device further facilitates survival of the dielectric wall material during front end of line, FEOL, processing.

Further, conventional forksheet devices typically requires a relatively high dielectric wall to avoid n/p merging over the wall, thus resulting in a higher gate. This may be prevented by the presented inventive concept.

Spatial terms such as "longitudinal" and "vertical", as used herein, are to be understood in relation to a substrate on which the transistor structure is to be placed or fabricated on, wherein "longitudinal" denotes an orientation or direction parallel to a main plane of extension of the substrate and "vertical" denotes an orientation or direction normal to the main plane of extension of the substrate. Throughout, the term "longitudinal" refers to an extension of the channel in which charge transport is to take place if not stated otherwise, i.e., along the channel. Correspondingly, relative spatial terms such as, "upper", "lower", "top", "bottom", "above", "under", "underneath", "below", are to be understood in relation to the substrate, as seen along the vertical/normal direction.

The terms "frontside" and "backside" of a substrate, on which the nanosheet device is arranged, refer respectively to the two mutually opposite (main) sides of the substrate, wherein the frontside is the side of the substrate on which the transistor (and any further active devices) are formed, and wherein the backside is the opposite side of the substrate.

The term "source/drain" as used herein is to be understood as a source or a drain. Hence, "source/drain region" may either be a source region or a drain region.

Preferably, the top surface of the dielectric wall is flush with a top surface of the channel region of the first transistor structure and with a top surface of the channel region of the second transistor structure.

Hence, the top surface of the dielectric wall is substantially on the same vertical level as the top surface of the channel region of the first and the second transistor structure. Compared to conventional forksheet devices where the dielectric wall vertically protrude above the top surface of the channel region, the present inventive concept facilitates reduction of the vertical extension of the nanosheet device. This may further reduce the height of the gate structure without compromising with the electrical properties of the device.

Preferably, a length of the channel region of the first transistor structure and a length of the channel region of the second transistor structure corresponds to a length of the gate structure.

The lengths referred to above is to be understood being lengths taken along the longitudinal extension.

Preferably, a distance between the third side surface of the dielectric wall and the fourth side surface of the dielectric wall corresponds to the length of the gate structure.

Hence, the length, i.e., the longitudinal extension, of the dielectric wall substantially equals the length, i.e., the longitudinal extension, of the gate structure. Consequently, the dielectric wall substantially has the same extension as the channel region.

Preferably, a bottom surface of the dielectric wall is arranged above a shallow trench isolation, STI, layer.

This is a particularly advantageous way of arranging the dielectric wall in the present device.

Preferably, the dielectric wall and the STI layer are formed by a same material.

This renders a simpler manufacturing of the nanosheet device since the dielectric wall can be formed at the same step as the STI.

Preferably, one or more of the dielectric wall and the STI layer comprise an oxide or nitride material.

These materials are particularly advantageous for the nanosheet device.

Preferably, each one of the first set of vertically stacked channel layers and the second set of vertically stacked channel layers comprises three or more stacked channel layers.

The present nanosheet device thus provides for stacking a larger number of channel layers compared to what is at present feasible in forksheet devices. This since the dielectric wall in general is wider than in conventional forksheet devices. This further facilitates reducing the footprint of the nanosheet device while maintaining or increasing the number of logic gates per area unit of the substrate.

Preferably, a shortest distance between the first and the second side surface of the dielectric wall is at least 50% of a width of each one of the first set of vertically stacked first channel layers and the second set of vertically stacked second channel layers.
This may prevent epi and gate metal shorting across in n/p devices. Further, (parasitic) capacitance between gate and drain may be reduced. Further, the 50% figure above has proven being a reasonable tradeoff in terms of performance and ease/difficulty with regard to lithography, etching and nanosheet release.

Preferably, a shortest distance between the first side surface and the second side surface of the dielectric wall is at least 10 nm.

This may facilitate manufacturing compared to devices having dielectric walls of smaller lateral dimensions.

Preferably, the first transistor structure comprises an n-FET type material and the second transistor structure comprises a p-FET type material.

This is generally the case when the nanosheet device is a forksheet device, thus enabling substantial scaling with regard to N-to-P spacing, which is substantially similar to the width of the dielectric wall. The n-FET/p-FET type material is thus typically present in the S/D region (in the form of epi layers) of the transistor structure in question, as appreciated by the skilled person.

A further scope of applicability of the present invention will become apparent from the detailed description given below. However, it should be understood that the detailed description and specific examples, while indicating preferred embodiments of the inventive concept, are given by way of illustration only, since various changes and modifications within the scope of the inventive concept will become apparent to those skilled in the art from this detailed description.

Hence, it is to be understood that the present inventive concept is not limited to the particular component parts of the device described or acts of the methods described as such device and method may vary. It is also to be understood that the terminology used herein is for purpose of describing particular embodiments only and is not intended to be limiting. It must be noted that, as used in the specification and the appended claims, the articles "a," "an," "the," and "said" are intended to mean that there are one or more of the elements unless the context clearly dictates otherwise. Thus, for example, reference to "a unit" or "the unit" may include several units, and the like. Furthermore, the words "comprising", "including", "containing" and similar wordings does not exclude other elements or steps.

### BRIEF DESCRIPTION OF THE DRAWINGS

The above, as well as additional objects, features, and advantages of the present inventive concept, will be better understood through the following illustrative and non-limiting detailed description, with reference to the appended drawings, in the drawings like reference numerals will be used for like elements unless stated otherwise.
Fig. 1 schematically depicts a prior art forksheet device.
Fig 2. schematically depicts a vertical-transversal cross-sectional profile of a nanosheet device according to embodiments of the invention.
Fig. 3A schematically shows a top view of a nanosheet device according to embodiments of the invention.
Figs 3B-3D schematically show vertical-transversal cross-sectional profiles along the nanosheet device of Fig. 3A.
Fig. 4A schematically shows a top view of a nanosheet device according to embodiments of the invention.
Fig. 4B schematically shows a vertical-longitudinal cross-sectional profile of the nanosheet device of Fig. 4A.

### DETAILED DESCRIPTION

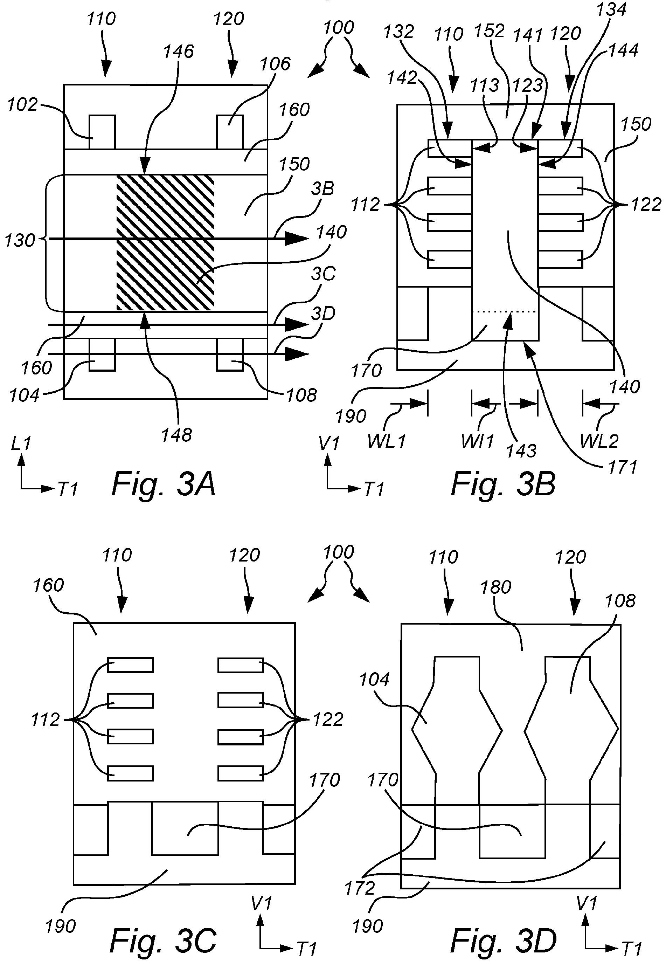

The present inventive concept will now be described more fully hereinafter with reference to the accompanying drawings, in which currently preferred variants of the inventive concept are shown. This inventive concept may, however, be embodied in many different forms and should not be construed as limited to the embodiments set forth herein; rather, these embodiments are provided for thoroughness and completeness, and to fully convey the scope of the inventive concept to the skilled person. Fig. 3A schematically shows a top view of a nanosheet device 100 (in longitudinal L1 versus transversal T1 direction). Arrows 3B, 3C and 3D in Fig. 3A refer to cross sections spanned in vertical V1 and transversal T1 extension of the nanosheet device. These cross sections are schematically depicted in Fig. 3B, 3C and 3D, i.e., the figures are numbered according to the arrows 3B, 3C, and 3D in Fig. 3A.

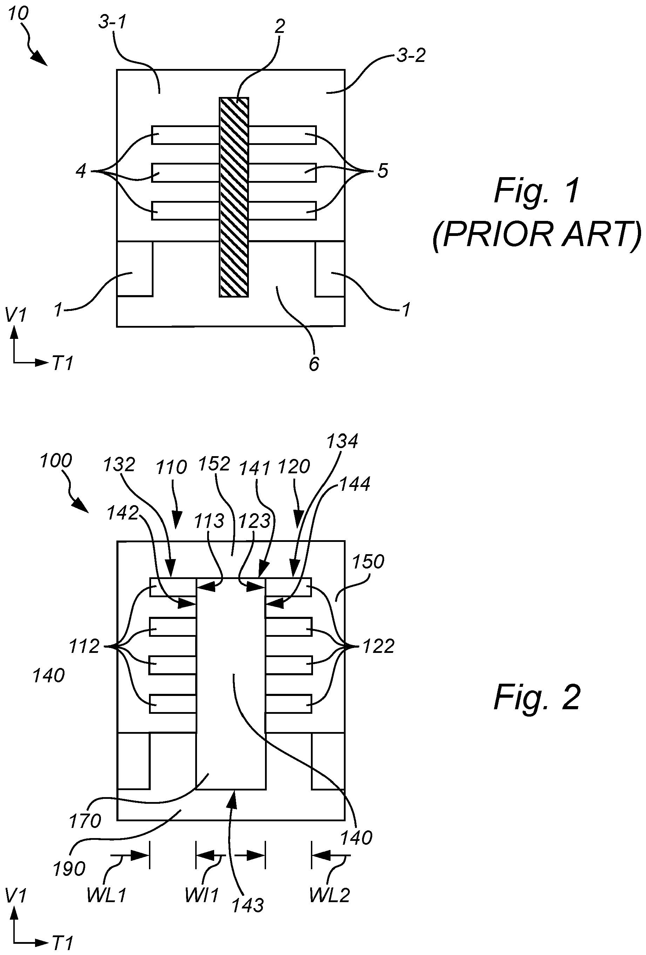

As depicted in the appended example figures, the nanosheet device 100 herein has a structure similar to a conventional forksheet device 100. Fig. 1 (prior art) schematically depicts such a conventional forksheet device. The term forksheet device thus refers to a device 10 comprising a first 4 and a second 5 set of vertically stacked channel layers (nanosheets) formed on opposite sides of a vertically oriented dielectric wall 2. Each channel layer of the first set 4 of vertically stacked channel layers has an inner edge contacting a first side of the dielectric wall 2 and each channel layer of the second set 5 of vertically stacked channel layers have an inner edge contacting a second side of the dielectric wall 2, opposite the first side. The forksheet device 10 comprises a first gate stack 3-1 surrounding the first set 4 of vertically stacked channel layers and contacting the first side of the dielectric wall 2, and a second gate stack 3-2 surrounding the second set 5 of vertically stacked channel layers and contacting the second side of the dielectric wall 2. The first transistor may comprise an N-type gate stack and the second transistor may comprise a P-type gate stack, or vice versa. Alternatively, the first and the second transistor may both comprise N-type gate stacks, or P-type gate stacks. Hence, four combinations of gate stack types may be possible within the scope of the claims.

A shallow trench isolation (STI) region 1 is typically present on respective transversal side of the gate stacks, i.e., trenched in the substrate on which the transistor is arranged. The material type of the STI region is, conventionally, different to the material of the dielectric wall 2.

Forming of the forksheet device 10 may be done according to a process flow known by a person skilled in the art, which may comprise forming a first set 4 of vertically stacked channel layers and a second set 5 of vertically stacked channel layers by a separating trench extending into the base portion thus forming the two vertically stacked channel layers. The trench may thereafter be filled with dielectric material to form the dielectric wall 2. A first gate stack 3-1, surrounding the first set 4 of vertically stacked channel layers and contacting the first side of the dielectric wall 2, is formed, as well as a second gate stack 3-2 surrounding the second set 5 of vertically stacked of channel layers and contacting the second side of the dielectric wall.

Heretofore, thus, a conventional forksheet device 10 (Fig.1) has been briefly described to facilitate understanding of the forthcoming description of the present inventive concept and its differences compared to prior art. Fig. 2 schematically depicts a cross-section, similar to that of Fig. 1, of the present nanosheet device to emphasize the structural differences compared to prior art. Fig. 2 depicts the same view as the view shown in Fig. 3B and will thus be further explained below.

More specific to the present disclosure and the terminology set forth in the claims, the nanosheet device 100 comprises a first 110 and a second 120 transistor structure. As the first 110 and the second 120 transistor structures generally are geometrically structurally similar, reference numerals may occasionally only be indicated in the drawings for one of the transistor structures 110, 120, e.g., for the first transistor structure 110. Each of the first 110 and the second 120 transistor structure comprises a source region 104, 108, a drain region 102, 106, and a channel region 130 extending between the source 104, 108 and the drain 102, 106 region. Hence, the channel region 130 may be viewed as an ordinary depletion region/zone in which the amount of longitudinally moving charge carriers (electron or holes) per unit of time is controlled by a voltage or potential field applied on the channel region 130 by the gate.

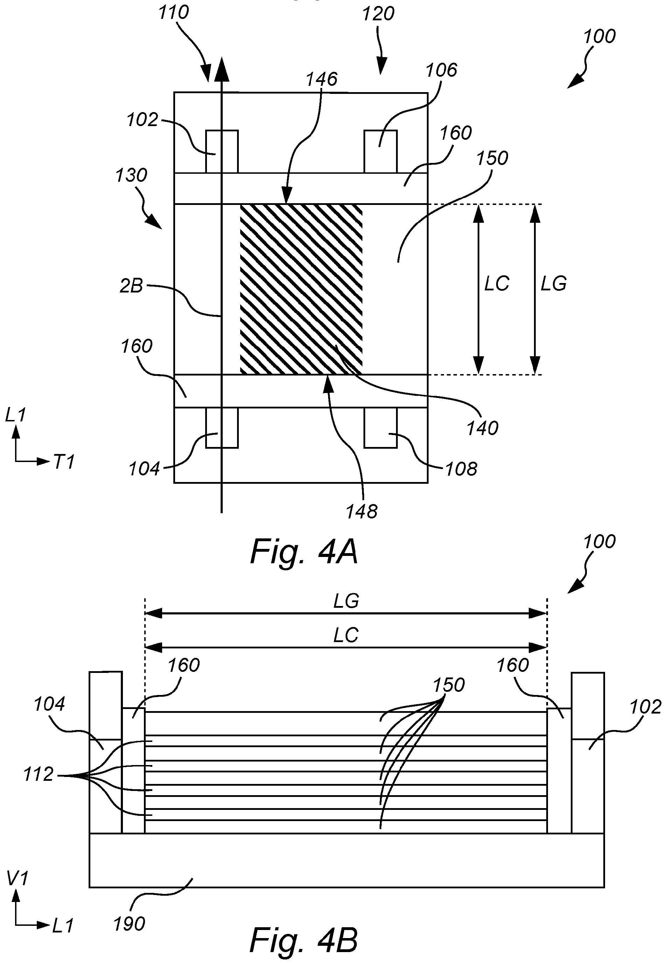

The nanosheet device 100 further comprises a dielectric wall 140. The dielectric wall 140 is best viewed in Fig. 3B. A lateral location, i.e., in an L1-T1 (longitudinal-transversal) plane of the dielectric wall 140 is viewed as a dashed region in Fig. 3A and Fig. 4A. This location is further discussed thoroughly below.

The nanosheet device 100 further comprises a gate structure 150. With reference to Figs 3A and 4A the gate structure 150 obscures the dielectric wall 140 (dashed region) when viewed from above.

The gate structure 150 may be different for the first 110 and the second 120 transistor structure, as appreciated by the skilled person, as a consequence of the possibly differing types of nanosheet stacks (N-type, P-type, etc.) of the different transistor structures 110, 120. Fig. 3C shows a cross-sectional profile of the nanosheet device 100 across the gate spacer 160, i.e., in the V1-T1 (vertical-transversal) plane. At this cross section the first 112 and the second 122 set of vertically stacked channel layers are transversally embedded in the gate spacer 150.

The nanosheet device 100 further comprises a gate spacer 160.

The channel region 130 of the first transistor structure 110 further comprises a first set 112 of vertically stacked channel layers, i.e., stacked along the vertical extension V1. Each channel layer of the first set 112 of vertically stacked channel layers has an inward facing surface 113 contacting a first side surface 142 of the dielectric wall 140.

The channel region 130 of the second transistor structure 120 further comprises a second set 122 of vertically stacked channel layers, stacked along the vertical extension V1. Each channel layer of the second set 122 of vertically stacked channel layers has an inward facing surface 123 contacting a second side surface 144, opposite to the first side surface, of the dielectric wall 140. The wording "opposite" is to be understood as "substantially opposite", as there by way of example may be significant local variations at the surfaces due to the small dimensions considered for the nanosheet device. This applies to other surfaces throughout this disclosure, as readily appreciated by the skilled person. As is further understood, corners may be rounded/blunt for the same reason.

A top portion 152 of the gate structure 150 is arranged above a top surface 141 of the dielectric wall 140.

The gate spacer 160 is arranged at a third 146 and a fourth 148 side surface of the dielectric wall 140. The third 146 and the fourth 148 side surface is thus transverse to the first 142 and the second 144 side surface of the dielectric wall 140.

The top surface 141 of the dielectric wall 140 may be flush with a top surface 132 of the channel region 130 of the first transistor structure 110 and with a top surface 134 of the channel region 130 of the second transistor structure 120.

A length LC of the channel region 130, i.e., a channel length LC of the first transistor structure 110 and a length LC of the channel region 130 of the second transistor structure 120 may correspond to a length LG of the gate structure 150. The lengths LG, LC thus refer to a distance along the longitudinal extension L1. This is best viewed in Figs 4A-B. It is to be understood that the correspondence is not necessarily exact. This since precise manufacturing obscures exact manufacture of components of transistors at the present length scales involved.

A distance between the third side surface 146 of the dielectric wall 140 and the fourth side surface 148 of the dielectric wall may correspond to the length LG of the gate structure 150. A bottom surface 143 of the dielectric wall 140 may be arranged above a shallow trench isolation, STI, layer 170.

The dielectric wall 140 and the STI layer 170 may be formed by a same material. The dielectric wall 140 and the STI layer 170 may be formed by a same material during the same processing step. In this case, the bottom surface 143 of the dielectric wall 140 manifestly coincides with a bottom surface 171 of the STI layer 170.

One or more of the dielectric wall 140 and the STI layer 170 may comprise an oxide or nitride material. Example materials in connection hereto may be SiO₂ (silicon oxide), SiN, Si₃N₄ (silicon nitride), SiOₓN_{y} (silicon oxynitride) and Si.

Each one of the first set of vertically stacked channel layers 112 and the second set of vertically stacked channel layers 122 may comprise three or more stacked channel layers 112, 122. However, any adequate number of stacked channel layers may be possible within the scope of the claims. By way of example, and as depicted in some of the appended drawings, the first 112 and the second 122 set of vertically stacked channel layers 122 may comprise four stacked channel layers 112, 122.

A shortest distance WI1 between the first 142 and the second 144 side surface of the dielectric wall may be at least 50% of a width WL1, WL2 of each one of the first set 112 of vertically stacked first channel layers and the second set 122 of vertically stacked second channel layers.

A shortest distance between the first side surface 142 and the second side surface 144 of the dielectric wall may be at least 10 nm. Preferably, the shortest distance between the first side surface 142 and the second side surface 144 of the dielectric wall is in the range 5-25 nm.

The first transistor structure 110 may comprise an n-FET type material and the second transistor structure 120 may comprise a p-FET type material. The opposite is manifestly also possible. Further, the first transistor structure 110, or, more correctly the two epi layers constituting the longitudinal ends of respective nanosheet stack, may be doped thereby defining an n-FET type or p-FET type transistor. Preferably, the vertically stacked channel layers 112, 122 themselves are undoped, although at least light doping of these may be possible. As familiar to those skilled in the art a possibly doped nanosheet stack may exhibit differing dopant profiles among the nanosheets of the stack of nanosheets.

Fig. 3D schematically shows a cross-sectional profile taken at arrow 3D in Fig. 3A. This cross-sectional profile schematically depicts a source/drain region of respective set of vertically stacked channel layers 112, 122. The first set of vertically stacked layers 112 may be longitudinally terminated by an N-epi layer 102, 104 of respective side of the channel region 130, and the second set of vertically stacked layers 122 may be longitudinally terminated by a P-epi layer 106, 108 of respective side of the channel region 130. The N-epi layer 102, 104 and the P-epi layer 106, 108 are preferably enclosed by a dielectric layer 180 in the V1-T1 (vertical-transversal) plane. Preferably, the dielectric layer 180 is a first inter layer dielectric (sometimes referred to as an ILD0) layer 180, located above an STI layer 170 comprising SiO₂. The depicted diamond/rhombic geometry of the N- and P-epi layers 104, 108 may originate from crystalline growth of these materials at the S/D region, and thus depends on the Miller indices (e.g., 110, 111, etc.) of these materials relative to the surface they are growth on.

To further facilitate understanding of the nanosheet device 100 described above, Fig. 4B shows a cross-sectional profile along the longitudinal extension L1 of the nanosheet device 100. The cross-sectional profile is taken along the arrow 4B in Fig. 4A. Figs 4A and 4B are thus clearly understood from the above description.

Accordingly, and in summary, in some variants discussed above, there has been described a nanosheet device 100 having a first 112 and a second 122 set of vertically stacked channel layers separated by a dielectric wall 130. The dielectric wall 130 is geometrically/physically enclosed between the first 112 and the second 122 set of vertically stacked channel layers, the gate structure 150 and the gate spacer 160, providing a nanosheet device 100 that may include further vertically aligned nanosheets in each channels stack 112, 122, thus increasing the number of logic operations per area unit of the nanosheet device 100. Other benefits are a smaller capacitance at cell level, reduction of parasitic series resistance, avoiding n/p merging over the dielectric wall, and reducing the relatively large number of etchback steps during replacement metal gate, RMG, formation.

The person skilled in the art realizes that the present inventive concept by no means is limited to the preferred embodiments described above. On the contrary, many modifications and variations are possible within the scope of the appended claims. Variations to the disclosed embodiments can be understood and effected by the skilled person in practicing the claimed invention, from a study of the drawings, the disclosure, and the appended claims.

## Claims

1. A nanosheet device (100) comprising:
a first (110) and a second (120) transistor structure, each (110, 120) comprising a source region (102, 106), a drain region (104, 108), and a channel region (130) extending between the source (102, 106) and the drain (104, 108) region,
a dielectric wall (140),
a gate structure (150), and
a gate spacer (160),
wherein the channel region (130) of the first transistor structure (110) comprises a first set (112) of vertically stacked channel layers, wherein each channel layer of the first set (112) of vertically stacked channel layers has an inward facing surface (113) contacting a first side surface (142) of the electrically insulating wall (140), and wherein the channel region (130) of the second transistor structure (120) comprises a second set (122) of vertically stacked channel layers, wherein each channel layer of the second set (130) of vertically stacked channel layers has an inward facing surface (123) contacting a second side surface (144), opposite to the first side surface (142), of the dielectric wall (140),
wherein a top portion (152) of the gate structure (150) is arranged above a top surface (141) of the dielectric wall (140), and
wherein the gate spacer (160) is arranged at a third (146) and a fourth (148) side surface of the dielectric wall (130), the third (146) and the fourth (148) side surface being transverse to the first (142) and the second (144) side surface of the dielectric wall (140).

2. The nanosheet device (100) according to claim 1, wherein the top surface (141) of the dielectric wall (140) is flush with a top surface (132) of the channel region (130) of the first transistor structure (110) and with a top surface (134) of the channel region (130) of the second transistor structure (130).

3. The nanosheet device according to claim 1 or 2, wherein a length (LC) of the channel region of the first transistor structure (110) and a length (LC) of the channel region of the second transistor (120) structure corresponds to a length of the gate structure (LG).

4. The nanosheet device (100) according to any one of claims 1-3, wherein a distance between the third side surface (146) of the dielectric wall (140) and the fourth side surface (148) of the dielectric wall (140) corresponds to the length (LG) of the gate structure (150).

5. The nanosheet device (100) according to any one of claims 1-4, wherein a bottom surface (143) of the dielectric wall (140) is arranged above a shallow trench isolation, STI, layer (170).

6. The nanosheet device (100) according to claim 5, wherein the dielectric wall (140) and the STI layer (170) are formed by a same material.

7. The nanosheet device (100) according to any one of claims 1-6, wherein one or more of the dielectric wall (140) and the STI layer (170) comprise an oxide or nitride material.

8. The nanosheet device (100) according to any one of claims 1-7, wherein each one of the first set (112) of vertically stacked channel layers and the second set (122) of vertically stacked channel layers comprises three or more stacked channel layers (112, 122).

9. The nanosheet device (100) according to any one of claims 1-8, wherein a shortest distance (WI1) between the first (142) and the second (144) side surface of the dielectric wall (140) is at least 50% of a width (WL1, WL2) of each one of the first set (112) of vertically stacked first channel layers and the second set (122) of vertically stacked second channel layers.

10. The nanosheet device (100) according to any one of claims 1-9, wherein a shortest distance (WI1) between the first side surface (142) and the second side surface (144) of the dielectric wall (140) is at least 10 nm.

11. The nanosheet device (100) according to any one of claims 1-10, wherein the first set (112) of vertically stacked channel layers comprises an n-FET type material and wherein the second set (122) of vertically stacked channel layers comprises a p-FET type material.
